(19)

Europäisches
Patentamt

European
Patent Office

Office européen
des brevets

(11) **EP 4 546 433 A1**

(12) **EUROPEAN PATENT APPLICATION**
published in accordance with Art. 153(4) EPC

(43) Date of publication:
**30.04.2025 Bulletin 2025/18**

(21) Application number: **23829575.2**

(22) Date of filing: **04.04.2023**

(51) International Patent Classification (IPC):
*H01L 31/0352* (2006.01)    *H01L 31/0392* (2006.01)
*H01L 31/042* (2014.01)     *H01L 31/18* (2006.01)
*H01L 31/0216* (2014.01)    *H01L 31/055* (2014.01)

(86) International application number:
**PCT/CN2023/086254**

(87) International publication number:
**WO 2024/001385 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.06.2022  CN 202210738973**

(71) Applicant: **Longi Green Energy Technology Co., Ltd.**
**Xi'an, Shaanxi 710100 (CN)**

(72) Inventors:
• **WU, Zhao**
**Xi' an, Shaanxi 710100 (CN)**
• **XIE, Junjie**
**Xi' an, Shaanxi 710100 (CN)**

(74) Representative: **Pfenning, Meinig & Partner mbB**
**Patent- und Rechtsanwälte**
**Theresienhöhe 11a**
**80339 München (DE)**

(54) **SOLAR CELL AND PREPARATION METHOD THEREFOR, AND PHOTOVOLTAIC MODULE**

(57)    This application provides a solar cell, a preparation method therefor, and a photovoltaic module, and relates to the field of photovoltaic technologies. The solar cell includes: a silicon substrate, and a low-absorption coefficient layer arranged on a light-receiving surface of the silicon substrate, where the low-absorption coefficient layer and the light-receiving surface of the silicon substrate have a same conductivity type; in a wavelength band of less than or equal to 400 nm, an absorption coefficient of the low-absorption coefficient layer is less than an absorption coefficient of the silicon substrate; a thickness x of the low-absorption coefficient layer ranges from 15 to 200 nm; and the low-absorption coefficient layer is in direct contact with the silicon substrate. The low-absorption coefficient layer and the light-receiving surface of the silicon substrate have the same conductivity type, to facilitate transport of minority carriers. The low-absorption coefficient layer absorbs a part of light in the wavelength band of less than or equal to 400 nm, so that light absorbed by the silicon substrate in the wavelength band of less than or equal to 400 nm is reduced. In this way, a concentration of non-equilibrium carriers in the light-receiving surface of the silicon substrate can be reduced, and the low-absorption coefficient layer fully absorbs the light in the wavelength band of less than or equal to 400 nm.

FIG. 1

EP 4 546 433 A1

# Description

## CROSS-REFERENCE TO RELATED APPLICATIONS

This application claims priority to Chinese Patent Application No. 202210738973.X, filed with the China National Intellectual Property Administration on June 27, 2022 and entitled "SOLAR CELL, PREPARATION METHOD THEREFOR, AND PHOTOVOLTAIC MODULE", which is incorporated herein by reference in its entirety.

## TECHNICAL FIELD

This application relates to the field of photovoltaic technologies, and in particular, to a solar cell, a preparation method therefor, and a photovoltaic module.

## BACKGROUND

Solar cells are power generation devices that directly converts sunlight into electrical energy output. As a clean energy source, solar cells have broad application prospects.

Currently, solar cells have a problem of poor short-wavelength response. The poor short-wavelength response leads to a decrease in photoelectric conversion efficiency of the solar cells.

## SUMMARY

This application provides a solar cell, a preparation method therefor, and a photovoltaic module, to resolve a problem that a solar cell has a poor short-wavelength response.

According to a first aspect of this application, a solar cell is provided, including:

a silicon substrate, and a low-absorption coefficient layer arranged on a light-receiving surface of the silicon substrate, where

the low-absorption coefficient layer and the light-receiving surface of the silicon substrate have a same conductivity type;

in a wavelength band of less than or equal to 400 nm, an absorption coefficient of the low-absorption coefficient layer is less than an absorption coefficient of the silicon substrate;

a thickness x of the low-absorption coefficient layer ranges from 15 to 200 nm, and a direction of the thickness is parallel to a direction in which the silicon substrate and the low-absorption coefficient layer are arranged; and

the low-absorption coefficient layer is in direct contact with the silicon substrate.

In embodiments of this application, a low-absorption coefficient layer and a light-receiving surface of a silicon substrate have a same conductivity type, to facilitate transport of minority carriers. In this way, non-equilibrium minority carriers in the light-receiving surface of the silicon substrate can be effectively conducted and collected, to facilitate reduction of a concentration of non-equilibrium carriers in the light-receiving surface of the silicon substrate, and facilitate reduction of recombination of the light-receiving surface of the silicon substrate, so that photoelectric conversion efficiency of a solar cell can be improved. The low-absorption coefficient layer is in direct contact with the silicon substrate, and in a wavelength band of less than or equal to 400 nm, an absorption coefficient of the low-absorption coefficient layer is less than an absorption coefficient of the silicon substrate. The low-absorption coefficient layer absorbs a part of light in the wavelength band of less than or equal to 400 nm, so that light absorbed by the silicon substrate in the wavelength band of less than or equal to 400 nm is reduced. In this way, the concentration of the non-equilibrium carriers in the light-receiving surface of the silicon substrate can be reduced, and the recombination of the light-receiving surface of the silicon substrate can be reduced. In addition, a thickness x of the low-absorption coefficient layer ranges from 15 to 200 nm. The low-absorption coefficient layer is not excessively thin, so that the light in the wavelength band of less than or equal to 400 nm can be fully absorbed; and the low-absorption coefficient layer is not excessively thick, and a concentration of minority carriers in the low-absorption coefficient layer is not excessively low, so that minority carriers in the silicon substrate are not injected into the low-absorption coefficient layer, to facilitate transport of the non-equilibrium minority carriers in the light-receiving surface of the silicon substrate. In this way, the non-equilibrium minority carriers in the light-receiving surface of the silicon substrate can be effectively conducted and collected, to facilitate reduction of the concentration of the non-equilibrium carriers in the light-receiving surface of the silicon substrate, and facilitate reduction of recombination of the light-receiving surface of the silicon substrate, so that the photoelectric conversion efficiency of the solar cell can be improved.

Optionally, a band gap of the low-absorption coefficient layer is greater than or equal to a band gap of the silicon substrate.

Optionally, the thickness x of the low-absorption coefficient layer ranges from 20 to 100 nm.

Optionally, the thickness of the low-absorption coefficient layer is $x = \dfrac{400}{4\pi\kappa_{min}}$, where $\kappa_{min}$ is a minimum extinction coefficient of the low-absorption coefficient layer in a wavelength band of 200 to 400 nm.

Optionally, in a wavelength band of 300 to 400 nm, an extinction coefficient of the low-absorption coefficient layer is greater than or equal to 0.1 and less than or equal to 2.

Optionally, in a wavelength band of 300 to 400 nm, an integral average extinction coefficient of the low-absorption coefficient layer is greater than or equal to 0.1 and less than or equal to 2.

Optionally, a material of the low-absorption coefficient layer is selected from at least one of boron carbide, zinc oxide, gallium phosphide, indium phosphide, cadmium sulfide, zinc sulfide, arsenic selenide, cadmium selenide, or zinc selenide.

Optionally, the material of the low-absorption coefficient layer is selected from zinc oxide; and the solar cell further includes: a front anti-reflection layer and a front electrode located on a side of the low-absorption coefficient layer away from the silicon substrate, where the front electrode penetrates the front anti-reflection layer to come into contact with the low-absorption coefficient layer.

Optionally, the low-absorption coefficient layer has a locally doped region, and the locally doped region is a front selective contact region; or the low-absorption coefficient layer is an entirely doped layer, and the low-absorption coefficient layer is a front selective contact layer; and

the solar cell further includes: a front electrode located on a side of the low-absorption coefficient layer away from the silicon substrate, where the front electrode is in contact with the front selective contact region or the front selective contact layer.

Optionally, the solar cell further includes: a buffer layer located between the silicon substrate and the low-absorption coefficient layer, where a material of the buffer layer is selected from at least one of silicon oxide, zinc sulfide, silicon carbide, aluminum nitride, or silicon nitride.

Optionally, a thickness of the buffer layer is less than or equal to 4 mm, and a direction of the thickness of the buffer layer is parallel to the direction in which the silicon substrate and the low-absorption coefficient layer are arranged.

Optionally, the light-receiving surface of the silicon substrate has a light-trapping structure.

According to a second aspect of this application, a photovoltaic module is provided, including a plurality of solar cells according to any one of the foregoing descriptions.

According to a third aspect of this application, a method for preparing the solar cell according to any one of the foregoing descriptions is provided, including: arranging a low-absorption coefficient layer on a light-receiving surface of a silicon substrate, where the low-absorption coefficient layer and the light-receiving surface of the silicon substrate have a same conductivity type; in a wavelength band of less than or equal to 400 nm, an absorption coefficient of the low-absorption coefficient layer is less than an absorption coefficient of the silicon substrate; a thickness x of the low-absorption coefficient layer ranges from 15 to 200 nm, and a direction of the thickness is parallel to a direction in which the silicon substrate and the low-absorption coefficient layer are arranged; and the low-absorption coefficient layer is in direct contact with the silicon substrate.

Optionally, the arranging a low-absorption coefficient layer on a light-receiving surface of a silicon substrate includes:

arranging the low-absorption coefficient layer on the light-receiving surface of the silicon substrate through chemical vapor deposition, evaporation deposition, or molecular beam epitaxy.

## BRIEF DESCRIPTION OF THE DRAWINGS

To describe the technical solutions in embodiments of this application more clearly, the following briefly describes the accompanying drawings required for describing the embodiments of this application. Apparently, the accompanying drawings in the following description show merely some embodiments of this application, and a person of ordinary skill in the art may still derive other accompanying drawings from these accompanying drawings without creative efforts.

FIG. 1 is a schematic structural diagram of a first solar cell according to an embodiment of this application;

FIG. 2 is a schematic structural diagram of a second solar cell according to an embodiment of this application;

FIG. 3 is a schematic structural diagram of a third solar cell according to an embodiment of this application; and

FIG. 4 is a schematic structural diagram of a fourth solar cell according to an embodiment of this application.

Descriptions of reference numerals:
1-silicon substrate, 2-low-absorption coefficient layer, 31-front functional layer, 312-front passivated contact layer, 313-front anti-reflection layer, 32-front electrode, 41-back functional layer, 411-back passivation layer, 412-back transport layer, 413-back anti-reflection layer, and 42-back electrode.

## DETAILED DESCRIPTION

The following clearly and completely describes the technical solutions in the embodiments of this application with reference to the accompanying drawings in the embodiments of this application. Apparently, the described embodiments are some embodiments of this application rather than all of the embodiments. All other embodiments obtained by a person of ordinary skill in the art based on the embodiments of this application without creative efforts shall fall within the protection scope of this application.

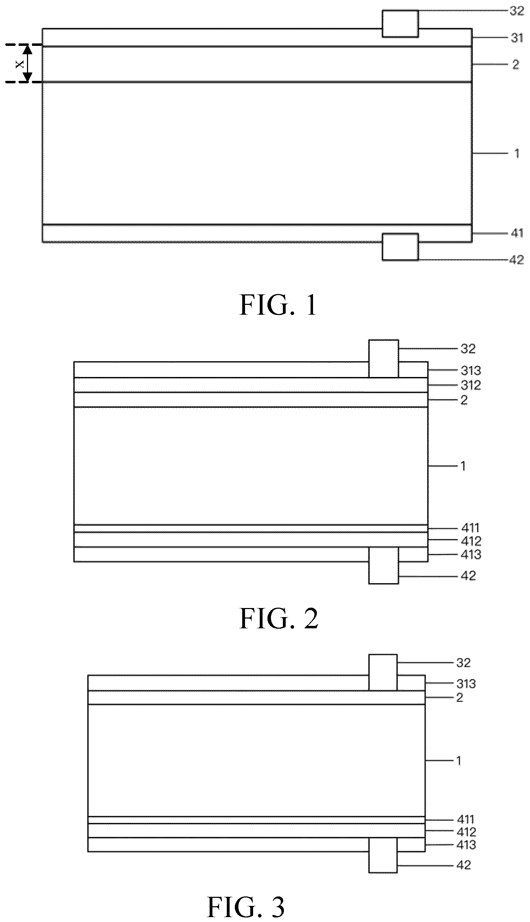

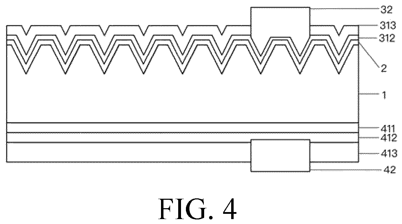

FIG. 1 is a schematic structural diagram of a first solar cell according to an embodiment of this application. FIG. 2 is a schematic structural diagram of a second solar cell according to an embodiment of this application. FIG. 3 is a schematic structural diagram of a third solar cell according to an embodiment of this application. FIG. 4 is a schematic structural diagram of a fourth solar cell according to an embodiment of this application. Referring to FIG. 1 to FIG. 4, the embodiments of this application provide a solar cell, including: a silicon substrate 1, and a low-absorption coefficient layer 2 arranged on a light-receiving surface of the silicon substrate.

Specifically, the applicant has found that, in existing technologies, a reason for a poor short-wavelength response of a solar cell is that: The light-receiving surface of the silicon substrate 1 has a large absorption coefficient for a short-wavelength band of less than or equal to 400 nm (nanometers). As a result, most of incident light is absorbed through a shallow depth of the light-receiving surface of the silicon substrate 1. For example, through a thickness of 10 nm from the light-receiving surface of the silicon substrate to the inside of the silicon substrate 1, the incident light in the wavelength band of less than or equal to 400 nm can be completely absorbed. In this way, under illumination, there is a high concentration of non-equilibrium carriers, and the non-equilibrium carriers of the high concentration cannot be effectively conducted and collected in time, resulting in severe recombination of the light-receiving surface of the silicon substrate 1.

More specifically, an absorption coefficient of a material is directly associated with optical parameters of the material, which is shown in, for example, the following formula: $\alpha = \frac{4\pi\kappa}{\lambda}$ . $\alpha$ a is the absorption coefficient, $\kappa$ is an extinction coefficient, $\lambda$ is a wavelength. For a silicon material, in a wavelength band of 400 nm, $\kappa = 0.387$; in a wavelength band of 350 nm, $\kappa = 3.014$; in a wavelength band of 300 nm, $\kappa = 4.639$; in a wavelength band of 288 nm, there is a peak extinction coefficient: $\kappa = 5.395$; and in a wavelength band of 200 nm, $\kappa = 2.909$. The extinction coefficient $\kappa$ is greater than 2.9 in a wavelength band of 200 to 350 nm, and is less than 2.9 only in a wavelength band of 350 to 400 nm, but sharply increases as the wavelength decreases. In the wavelength band of less than or equal to 400 nm, the silicon material has a smallest low-absorption coefficient in the wavelength band of 400 nm: $\alpha = 0.0122nm^{-1}$. In other words, through a thickness: $\frac{1}{\alpha} = 82nm$ , most of incident light in the wavelength band of 400 nm can be absorbed. However, for the wavelength band of 350 nm, only a thickness of 10 nm is required, so that most of incident light in the wavelength band of 350 nm can be absorbed. For incident light in the wavelength band of 200 to 350 nm, the silicon material only needs to have a thickness of less than 10 nm, to achieve absorption of most of the incident light. In addition, a yield of non-equilibrium carriers in the light-receiving surface of the silicon substrate is $G \propto \int f \cdot \alpha \cdot e^{-\alpha x} dx$, where the absorption coefficient $\alpha$ is directly proportional to G, and the two have direct impact. To be specific, if the absorption coefficient $\alpha$ decreases by an order of magnitude, G may also decrease by an order of magnitude. Therefore, because the light-receiving surface of the silicon substrate 1 has a large absorption coefficient for the short-wavelength band of less than or equal to 400 nm, the light-receiving surface of the silicon substrate 1 has a high concentration of non-equilibrium carriers.

For the foregoing problems, in this application, a low-absorption coefficient layer 2 and a light-receiving surface of a silicon substrate 1 have a same conductivity type, to facilitate transport of minority carriers. In this way, non-equilibrium minority carriers in the light-receiving surface of the silicon substrate 1 can be effectively conducted and collected, to facilitate reduction of a concentration of non-equilibrium carriers in the light-receiving surface of the silicon substrate 1, and facilitate reduction of recombination of the light-receiving surface of the silicon substrate 1, so that photoelectric conversion efficiency of a solar cell can be improved. The low-absorption coefficient layer 2 is in direct contact with the silicon substrate 1, and in a wavelength band of less than or equal to 400 nm, an absorption coefficient of the low-absorption coefficient layer 2 is less than an absorption coefficient of the silicon substrate 1. The low-absorption coefficient layer 2 absorbs a part of light in the wavelength band of less than or equal to 400 nm, so that light absorbed by the silicon substrate 1 in the wavelength band of less than or equal to 400 nm is reduced. In this way, the concentration of the non-equilibrium carriers in the light-receiving surface of the silicon substrate 1 can be reduced, and the recombination of the light-receiving surface of the silicon substrate 1 can be reduced, so that the photoelectric conversion efficiency of the solar cell can be improved. In addition, a thickness x of the low-absorption coefficient layer 2 ranges from 15 to 200 nm. The low-absorption coefficient layer 2 is not excessively thin, so that the light in the wavelength band of less than or equal to 400 nm can be fully absorbed; and the low-absorption coefficient layer 2 is not excessively thick, and a concentration of minority carriers in the low-absorption coefficient layer 2 is not excessively low, so that minority carriers in the silicon substrate 1 are not injected into the low-absorption coefficient layer 2, to facilitate transport of the non-equilibrium minority carriers in the light-receiving surface of the silicon substrate 1. In this way, the non-equilibrium minority carriers in the light-receiving surface of the silicon substrate 1 can be effectively conducted and collected, to facilitate reduction of the concentration of the non-equilibrium carriers in the light-receiving surface of the silicon substrate 1, and facilitate reduction of recombination of the light-receiving surface of the silicon substrate 1.

For example, the thickness x of the low-absorption coefficient layer 2 may be 15 nm, 30 nm, 50 nm, 90 nm, 110 nm, 130 nm, 170 nm, or 200 nm. A direction of the thickness is parallel to the direction in which the silicon substrate 1 and the low-absorption coefficient layer 2 are arranged, and directions of thicknesses in this specification each is defined as the same.

The low-absorption coefficient layer 2 is in direct contact with the silicon substrate 1, and a status of an interface between the two is not specifically limited. For example, the interface between the two may be an epitaxial interface or a chemical bond interface. The epitaxial interface is a lattice-matched interface, and there is almost no interface through a high-precision transmission electron microscope. The low-absorption coefficient layer 2 and the silicon substrate 1 may be considered as a whole. The chemical bond interface may be an interface on which the low-absorption coefficient layer 2 and the silicon substrate 1 are bonded. On the interface, lattices in some regions may be matched, and lattice in the other regions are mismatched. Through a transmission electron microscope, there is a display interface between the low-absorption coefficient layer 2 and the silicon substrate 1. It should be noted that, on the interface between the low-absorption coefficient layer 2 and the silicon substrate 1, a larger region in which lattices are matched indicates that it is more conducive to conduction or transport of carriers on the interface between the two. A doping concentration, a doping type, a thickness, and the like of the silicon substrate 1 are all not limited in this application.

The low-absorption coefficient layer 2 may be made of a polycrystalline material or a monocrystalline material, which is not specifically limited. For example, the low-absorption coefficient layer 2 may be made of the monocrystalline material, so that an interface with excellent performance can be formed between the low-absorption coefficient layer 2 and the silicon substrate 1.

Optionally, a band gap of the low-absorption coefficient layer 2 is greater than or equal to a band gap of the silicon substrate 1, which can ensure that the silicon substrate 1 is a main absorbing material for light in a wavelength band of greater than 400 nm. In other words, because the silicon substrate 1 has a large absorption coefficient in the wavelength band of less than or equal to 400 nm, the light-receiving surface of the silicon substrate 1 has a high concentration of non-equilibrium carriers. In this application, the silicon substrate 1 absorbs less light in the wavelength band of less than or equal to 400 nm, to reduce the concentration of the non-equilibrium carriers in the light-receiving surface of the silicon substrate 1. In addition, as much light as possible in the wavelength band of greater than 400 nm is absorbed by the silicon substrate 1.

Optionally, the thickness x of the low-absorption coefficient layer 2 ranges from 20 to 100 nm. In this case, the thickness of the low-absorption coefficient layer 2 is suitable, so that the light in the wavelength band of less than or equal to 400 nm can be fully absorbed, and the concentration of the minority carriers in the low-absorption coefficient layer 2 is not excessively low, so that the minority carriers in the silicon substrate 1 are not injected into the low-absorption coefficient layer 2, to facilitate transport of the non-equilibrium minority carriers in the light-receiving surface of the silicon substrate 1. In this way, the non-equilibrium minority carriers in the light-receiving surface of the silicon substrate 1 can be effectively conducted and collected, to facilitate reduction of the concentration of the non-equilibrium carriers in the light-receiving surface of the silicon substrate 1, and facilitate reduction of recombination of the light-receiving surface of the silicon substrate 1.

For example, the thickness x of the low-absorption coefficient layer 2 may be 20 nm, 30 nm, 42 nm, 55 nm, 63 nm, 77 nm, 89 nm, or 100 nm.

Optionally, the thickness of the low-absorption coefficient layer 2 is $x = \dfrac{400}{4\pi\kappa_{min}}$, where $\kappa_{min}$ is a minimum extinction coefficient of the low-absorption coefficient layer 2 in a wavelength band of 200 to 400 nm. In this case, the thickness x of the low-absorption coefficient layer 2 is suitable, so that the light in the wavelength band of less than or equal to 400 nm can be fully absorbed, and the concentration of the minority carriers in the low-absorption coefficient layer 2 is not excessively low, so that the minority carriers in the silicon substrate 1 are not injected into the low-absorption coefficient layer 2, to facilitate transport of the non-equilibrium minority carriers in the light-receiving surface of the silicon substrate 1. In this way, the non-equilibrium minority carriers in the light-receiving surface of the silicon substrate 1 can be effectively conducted and collected, to facilitate reduction of the concentration of the non-equilibrium carriers in the light-receiving surface of the silicon substrate 1, and facilitate reduction of recombination of the light-receiving surface of the silicon substrate 1.

Optionally, in a wavelength band of 300 to 400 nm, an extinction coefficient of the low-absorption coefficient layer 2 is greater than or equal to 0.1 and less than or equal to 2. The extinction coefficient of the low-absorption coefficient layer 2 is directly proportional to the absorption coefficient of the low-absorption coefficient layer 2. If the extinction coefficient of the low-absorption coefficient layer 2 is in the wavelength band of 300 to 400 nm, the absorption coefficient of the low-absorption coefficient layer 2 is suitable, which is suitable for the amount of light absorbed by the low-absorption coefficient layer 2 in the wavelength band of 300 to 400 nm, and suitable for the amount of light absorbed by the silicon substrate 1 in the wavelength band of 300 to 400 nm, so that the concentration of the non-equilibrium carriers in the light-receiving surface of the silicon substrate 1 can be reduced.

For example, in the wavelength band of 300 to 400 nm, the extinction coefficient of the low-absorption coefficient layer 2 is 0.1, 0.3, 0.5, 0.8, 0.9, 1.1, 1.5, 1.9, or 2.

Optionally, in a wavelength band of 300 to 400 nm, an integral average extinction coefficient of the low-absorption coefficient layer 2 is greater than or equal to 0.1 and less than or equal to 2. The integral average extinction coefficient is obtained in the following manner: By using a wavelength band of 300 to 400 nm as an integral interval and using the extinction coefficient of the low-absorption coefficient layer 2 as an integrated function, integration is performed, and then an integration result is divided by a length of the integral interval. If the extinction coefficient of the low-absorption coefficient layer 2 is in the wavelength band of 300 to 400 nm, the absorption coefficient of the low-absorption coefficient layer 2 is suitable, which is suitable for the amount of light absorbed by the low-absorption coefficient layer 2 in the wavelength band of 300 to 400 nm, and suitable for the amount of light absorbed by the silicon substrate 1 in the wavelength band of 300 to 400 nm, so that the concentration of the non-equilibrium carriers in the light-receiving surface of the silicon substrate 1 can be reduced.

For example, in the wavelength band of 300 to 400 nm, the integral average extinction coefficient of the low-absorption coefficient layer 2 is 0.1, 0.3, 0.46, 0.73, 0.92, 1.1, 1.5, 1.88, or 2.

Optionally, a material of the low-absorption coefficient layer 2 is selected from at least one of boron carbide, zinc oxide, gallium phosphide, indium phosphide, cadmium sulfide, zinc sulfide, arsenic selenide, cadmium selenide, or zinc selenide. The low-absorption coefficient layer 2 of the foregoing material has a suitable absorption coefficient in the wavelength band of 300 to 400 nm, so that the concentration of the non-equilibrium carriers in the light-receiving surface of the silicon substrate 1 can be reduced. In addition, lattice constants of the low-absorption coefficient layer 2 of the foregoing material and the silicon substrate 1 are relatively close, and an epitaxial interface or a chemical bond interface is prone to be formed between the two, to facilitate conduction or transport of carriers on the interface between the two, thereby improving the photoelectric conversion efficiency of the solar cell.

More specifically, a lattice constant of silicon in the silicon substrate 1 is 5.43Å (angstroms). A lattice constant of boron carbide is 5.19Å, and in the wavelength band of 300 to 400 nm, an extinction coefficient of boron carbide roughly ranges from 1.05 to 0.76. If boron carbide is used as the material of the low-absorption coefficient layer 2, the concentration of the non-equilibrium carriers in the light-receiving surface of the silicon substrate 1 can be reduced. In addition, the lattice constants of the low-absorption coefficient layer 2 of the boron carbide material and the silicon substrate 1 are relatively close, and the epitaxial interface or the chemical bond interface is prone to be formed between the two, to facilitate conduction or transport of the carriers on the interface between the two, thereby improving the photoelectric conversion efficiency of the solar cell. Similarly, a lattice constant of zinc oxide is 5.2Å, and in the wavelength band of 300 to 400 nm, an extinction coefficient of zinc oxide roughly ranges from 0.196 to 0.254 and from 0.254 to 0.109. A lattice constant of gallium phosphide is 5.44Å, and in the wavelength band of 300 to 400 nm, an extinction coefficient of gallium phosphide roughly ranges from 2.1 to 0.275. A lattice constant of indium phosphide is 5.87Å, and in the wavelength band of 300 to 400 nm, an extinction coefficient of indium phosphide roughly ranges from 1.7 to 2.2 and from 2.2 to 1.7. A lattice constant of cadmium sulfide is 5.86Å, and in the wavelength band of 300 to 400 nm, an extinction coefficient of cadmium sulfide roughly ranges from 0.39 to 0.34. A lattice constant of zinc sulfide is 5.47Å, and in the wavelength band of 300 to 400 nm, an extinction coefficient of zinc sulfide roughly ranges from 0.357 to 0.008. A lattice constant of arsenic selenide is 4.51Å, and in the wavelength band of 300 to 400 nm, an extinction coefficient of arsenic selenide roughly ranges from 1.66 to 1.86 and from 1.86 to 1.65. A lattice constant of cadmium selenide is 5.86Å, and in the wavelength band of 300 to 400 nm, an extinction coefficient of cadmium selenide roughly ranges from 1.34 to 0.56. A lattice constant of zinc selenide is 5.66Å, and in the wavelength band of 300 to 400 nm, an extinction coefficient of zinc selenide roughly ranges from 0.79 to 0.48.

Optionally, referring to FIG. 3, the material of the low-absorption coefficient layer 2 is selected from zinc oxide; and the solar cell further includes: a front anti-reflection layer 313 and a front electrode 32 located on a side of the low-absorption coefficient layer 2 away from the silicon substrate 1, where the front electrode 32 penetrates the front anti-reflection layer 313 to come into contact with the low-absorption coefficient layer 2. In other words, the material of the low-absorption coefficient layer 2 is selected from zinc oxide. The low-absorption coefficient layer 2 has at least two roles: One is a low-absorption coefficient role in the wavelength band of 300 to 400 nm, and the other is a front carrier transport role or a front selective contact role. In this way, there is no need to separately arrange a front carrier transport layer, so that a structure of the solar cell can be simplified. Because zinc oxide naturally has an N-type conductivity type, whether the low-absorption coefficient layer 2 of the zinc oxide material is doped is not specifically limited. For example, the low-absorption coefficient layer 2 of the zinc oxide material may not be doped, and a type of the silicon substrate 1 is also the N-type conductivity type. Alternatively, an entire region or a local region of the low-absorption coefficient layer 2 of the zinc oxide material has surface doping, so that the conductivity type of the low-absorption coefficient layer 2 of the zinc oxide material can be improved. For example, an element such as aluminum, indium, or gallium may be doped in the low-absorption coefficient layer 2 of the zinc oxide material. In this application, a doping concentration and the like of the low-absorption coefficient layer 2 are not specifically limited.

Optionally, the thickness of the low-absorption coefficient layer 2 of the zinc oxide material may range from 15 to 100 nm. The low-absorption coefficient layer 2 of the zinc oxide material in the foregoing thickness range has a good low-absorption coefficient role, and a good front carrier transport role or front selective contact role in the wavelength band of 300 to 400 nm. For example, the thickness of the low-absorption coefficient layer 2 of the zinc oxide material may be 15 nm, 23 nm, 36 nm, 45 nm, 58 nm, 66 nm, 79 nm, 88 nm, or 100 nm.

Optionally, the thickness of the low-absorption coefficient layer 2 of the zinc oxide material may further range from 20 to 50 nm. The low-absorption coefficient layer 2 of the zinc oxide material in the foregoing thickness range has a better low-absorption coefficient role, and a better front carrier transport role or front selective contact role in the wavelength band of 300 to 400 nm. For example, the thickness of the low-absorption coefficient layer 2 of the zinc oxide material may be 20 nm, 23 nm, 29 nm, 36 nm, 38 nm, 42 nm, 47 nm, or 50 nm.

A material, a structure, a thickness, and the like of the front anti-reflection layer 313 are all not specifically limited. For example, the material of the front anti-reflection layer 313 may be selected from at least one of silicon nitride, magnesium fluoride, silicon oxide, zinc sulfide, silicon oxynitride, aluminum nitride, titanium nitride, aluminum oxide, or titanium oxide. For example, the front anti-reflection layer 313 may be a laminated-layer structure of an aluminum nitride layer and a titanium nitride layer.

A material, a structure, a size, and the like of the front electrode 32 are all not specifically limited. For example, the material of the front electrode 32 may be selected from at least one of silver, copper, nickel, zinc, or aluminum. The front electrode 32 may be a single-layer or laminated-layer structure.

Optionally, the low-absorption coefficient layer 2 has a locally doped region, and the locally doped region is a front selective contact region; and the solar cell further includes: a front electrode 32 located on a side of the low-absorption coefficient layer 2 away from the silicon substrate 1, where the front electrode 32 is in contact with the front selective contact region. In other words, the entire low-absorption coefficient layer 2 plays a low-absorption coefficient role in the wavelength band of 300 to 400 nm. In addition to playing the low-absorption coefficient role in the locally doped region, the low-absorption coefficient layer 2 also plays a front carrier transport role or a front selective contact role. In this way, there is no need to separately arrange a front carrier transport layer, so that a structure of the solar cell can be simplified. In this application, a doping concentration and the like of the front selective contact region are not specifically limited.

Optionally, referring to FIG. 2, the low-absorption coefficient layer 2 is an entirely doped layer, and the low-absorption coefficient layer 2 is simultaneously used as a front selective contact layer; and the solar cell further includes: a front electrode 32 located on a side of the low-absorption coefficient layer 2 away from the silicon substrate 1, where the front electrode 32 is in contact with the low-absorption coefficient layer 2. In other words, the entirely doped low-absorption coefficient layer 2 has at least two roles: One is a low-absorption coefficient role in the wavelength band of 300 to 400 nm, and the other is a front carrier transport role. In this way, there is no need to separately arrange a front selective contact layer, so that a structure of the solar cell can be simplified. In this application, a doping concentration and the like of the low-absorption coefficient layer 2 are not specifically limited.

Optionally, the solar cell may further include: a buffer layer (not shown in the figure) located between the silicon substrate 1 and the low-absorption coefficient layer 2, where a material of the buffer layer is selected from at least one of silicon oxide, zinc sulfide, silicon carbide, aluminum nitride, or silicon nitride. The buffer layer of the foregoing material has good lattice matching performance and good electrical performance with both the silicon substrate 1 and the low-absorption coefficient layer 2, so that contact performance between the silicon substrate 1 and the low-absorption coefficient layer 2 is better.

Optionally, a thickness of the buffer layer is less than or equal to 4 mm, and a direction of the thickness of the buffer layer is parallel to the direction in which the silicon substrate 1 and the low-absorption coefficient layer 2 are arranged. When the thickness of the buffer layer is in the range, there is good lattice matching performance for the silicon substrate 1 and the low-absorption coefficient layer 2.

For example, the thickness of the buffer layer may be 50 $\mu$m, 150 $\mu$m, 500 $\mu$m, 1.2 mm, 2.4 mm, 3.2 mm, 3.7 mm, or 4 mm.

Optionally, a thickness of the buffer layer is less than or equal to 2 mm; and when the thickness of the buffer layer is in the range, there is good lattice matching performance for the silicon substrate 1 and the low-absorption coefficient layer 2. For example, the thickness of the buffer layer may be 50 $\mu$m, 150 $\mu$m, 500 $\mu$m, 980 $\mu$m, 1.2 mm, 1.5 mm, 1.8 mm, or 2 mm.

Optionally, the light-receiving surface of the silicon substrate 1 has a light-trapping structure. Because a shape of the low-absorption coefficient layer 2 is adapted to the light-receiving surface of the silicon substrate 1, the low-absorption coefficient layer 2 also has the light-trapping structure, so that a light-trapping effect of the solar cell can be improved.

Referring to FIG. 1, the solar cell may further include: a front functional layer 31 located on the light-receiving surface of the low-absorption coefficient layer 2. The front functional layer 31 may include one or more layers of structures such as a front passivation layer, a front transport layer, or the front anti-reflection layer 313. A material, a structure, and the like of the front functional layer 31 are all not specifically limited. For example, a part of the front anti-reflection layer 313 may further have a field passivation or chemical passivation function. For example, the front transport layer mainly plays a role of selecting and conducting majority carriers in the light-receiving surface of the silicon substrate 1, and also includes a chemical passivation function for the light-receiving surface. For example, a material of the front transport layer may be selected from at least one of intrinsic amorphous silicon and doped amorphous silicon, silicon oxide and doped polysilicon, or silicon oxide and indium tin oxide.

Referring to FIG. 1, a back surface of the silicon substrate 1 may have diffused or injected pn junctions or a heavily doped layer or a heavily doped region. The solar cell may further include: a back functional layer 41 located on the back surface of the silicon substrate 1. The back functional layer 41 may include one or more layers of structures such as a back passivation layer 411, a back transport layer 412, or a back anti-reflection layer 413. A material, a structure, and the like of the back functional layer 41 are all not specifically limited. The back anti-reflection layer 413 may include one or more layers of anti-reflection structures such as silicon nitride, silicon oxide, silicon oxynitride, aluminum nitride, titanium nitride, aluminum oxide, or titanium oxide. For example, a part of the back anti-reflection layer 413 has a field passivation or chemical passivation function. For example, the back transport layer 412 mainly plays a role of selecting and conducting majority carriers in the back surface of the silicon substrate 1. For example, a material of the back transport layer 412 may be selected from at least one of intrinsic amorphous silicon and doped amorphous silicon, silicon oxide and doped polysilicon, or silicon oxide and zinc oxide. The solar cell may further include a back electrode 42. A material of the back electrode 42 is not specifically limited. For example, the material of the back electrode 42 may be a metal material, which may be, for example, at least one of gold, silver, copper, aluminum, nickel, indium, or gallium. The back electrode 42 may penetrate or partially penetrate the back functional layer 41.

This application further provides a photovoltaic module, including a plurality of solar cells according to any one of the foregoing descriptions. The photovoltaic module can achieve the same or similar beneficial effects. To avoid repetition, details are not described in relevant parts.

This application further provides a method for preparing the solar cell according to any one of the foregoing descriptions, including the following steps: arranging a low-absorption coefficient layer on a light-receiving surface of a silicon substrate, where the low-absorption coefficient layer and the light-receiving surface of the silicon substrate have a same conductivity type; in a wavelength band of less than or equal to 400 nm, an absorption coefficient of the low-absorption coefficient layer is less than an absorption coefficient of the silicon substrate; a thickness x of the low-absorption coefficient layer ranges from 15 to 200 nm, and a direction of the thickness is parallel to a direction in which the silicon substrate and the low-absorption coefficient layer are arranged; and the low-absorption coefficient layer is in direct contact with the silicon substrate.

The preparation method can achieve the same or similar beneficial effects as the solar cell according to any one of the foregoing descriptions. To avoid repetition, details are not described in relevant parts.

Optionally, a low-absorption coefficient layer 2 may be arranged on the light-receiving surface of a silicon substrate 1 through chemical vapor deposition, evaporation deposition, or molecular beam epitaxy. Through the foregoing preparation manner, the low-absorption coefficient layer 2 having excellent performance and a good contact interface with the silicon substrate 1 is easily prepared.

It should be noted that, the foregoing solar cell, the photovoltaic module, and the method for preparing the solar cell may be referred to each other, and can achieve the same or similar beneficial effects. To avoid repetition, details are not described in relevant parts.

This application is further described below with reference to specific embodiments.

Embodiment 1

As shown in FIG. 2, a back surface of a solar cell is a tunnel oxide passivated contact (TOPCon) structure.

An n-type silicon wafer is used as a silicon substrate 1. The thickness and the doping concentration of the silicon substrate are not limited. For example, the silicon substrate 1 has a doping concentration ranging from $10^{10}/cm^3$ to $10^{16}/cm^3$, and a thickness that may range from 30 to 150 $\mu$m (micron), or from 50 to 200 $\mu$m. For another example, the silicon substrate 1 with a low doping concentration of $10^{10}/cm^3$ to $10^{14}/cm^3$ may have a large thickness, which may range from 80 to 150 $\mu$m. The silicon substrate 1 with a high doping concentration of $10^{14}/cm^3$ to $10^{16}/cm^3$ may have a small thickness, which may range from 30 to 80 $\mu$m. A light-receiving surface of the silicon substrate 1 may be a planar structure or a low-roughness light-trapping structure, and a back surface of the silicon substrate 1 has a textured light-trapping structure.

A low-absorption coefficient layer 2 is arranged on the light-receiving surface of the silicon substrate 1. The low-absorption coefficient layer 2 is made of a material including gallium phosphide (GaP) or indium phosphide (InP), has a thickness of 20 to 100 nm, for example, 20 to 50 nm, and has an n-type conductivity type. The low-absorption coefficient layer 2 is prepared by using a chemical vapor epitaxy deposition method, for example, a chemical molecular beam epitaxy process or an atomic layer deposition process.

A front passivated contact layer 312 is arranged on a light-receiving surface of the low-absorption coefficient layer 2. The front passivated contact layer 312 is made of a material including wide-band gap group III-V materials, for example, AlGaAs, AlGaInP, or GaInAs (where the stoichiometric ratio is not limited).

A front anti-reflection layer 313 is arranged on a light-receiving surface of the front passivated contact layer 312. A material of the front anti-reflection layer 313 includes silicon nitride, magnesium fluoride, silicon oxide, or the like.

A front electrode 32 penetrates the front anti-reflection layer 313 to come into electrical contact with the front passivated contact layer 312, or to come into partial contact with the low-absorption coefficient layer 2. The front electrode 32 is a single-layer or laminated-layer structure formed by at least one of silver, copper, nickel, zinc, or aluminum.

The back surface of the solar cell is a conventional TOPCon structure having a back passivation layer 411. A material of the back passivation layer 411 is silicon oxide. The back transport layer 412 is made of doped polysilicon. A doping type of the back transport layer 412 is the same as that of the back surface of the silicon substrate 1. If the low-absorption coefficient layer 2 is made of an n-type material, the back surface of the silicon substrate 1 is a p-type diffusion or injection layer, and the back transport layer 412 is made of p-type polysilicon. If the low-absorption coefficient layer 2 is made of a p-type material, the back surface of the silicon substrate 1 may be a non-diffused or diffused or ion-injected n-type heavily doped layer, and the back transport layer 412 is made of n-type polysilicon.

A back anti-reflection layer 413 is arranged on a back surface of the back transport layer 412, and is made of at least one of silicon nitride, magnesium fluoride, or silicon oxide.

A back electrode 42 penetrates the back anti-reflection layer 413 to come into electrical contact with the back transport layer 412, or partially penetrates the back transport layer 412 and the back passivation layer 411 to come into contact with the back surface of the silicon substrate 1. A material of the back electrode 42 is selected from at least one of silver, copper, nickel, zinc, or aluminum, to form a single-layer structure or a laminated-layer structure.

Embodiment 2

As shown in FIG. 3, an n-type silicon wafer is used as a silicon substrate 1. The thickness and the doping concentration of the silicon substrate are not limited. For example, the silicon substrate 1 has a doping concentration ranging from $10^{10}/cm^3$ to $10^{16}/cm^3$, and a thickness ranging from 30 to 150 $\mu$m. For example, the silicon substrate 1 with a low doping concentration of $10^{10}/cm^3$ to $10^{14}/cm^3$ may have a large thickness, which may range from 80 to 150 $\mu$m. The silicon substrate 1 with a high doping concentration of $10^{14}/cm^3$ to $10^{16}/cm^3$ may have a small thickness, which may range from 30 to 80

$\mu$m. A light-receiving surface of the silicon substrate 1 may be a planar structure or a low-roughness light-trapping structure, and a back surface of the silicon substrate 1 has a textured light-trapping structure.

A low-absorption coefficient layer 2 is arranged on the light-receiving surface of the silicon substrate 1. The low-absorption coefficient layer 2 is made of a material including zinc oxide, and has a thickness of 15 to 100 nm, for example, 20 to 50 nm. Zinc oxide naturally has an n-type conductivity type. Doping may be performed on zinc oxide to improve the conductivity or enhance the conductivity type. For example, an element such as aluminum, indium, or gallium may be doped in zinc oxide. The low-absorption coefficient layer 2 may be prepared by using a process such as chemical vapor deposition, evaporative deposition, or molecular beam epitaxy. A buffer layer may exist between the low-absorption coefficient layer 2 and the silicon substrate 1. A material of the buffer layer may be selected as, for example, silicon oxide, zinc sulfide, silicon carbide, aluminum nitride, or silicon nitride. A thickness of the buffer layer does not exceed 4 nm. Optionally, the thickness of the buffer layer does not exceed 2 nm.

A front anti-reflection layer 313 is arranged on a light-receiving surface of the low-absorption coefficient layer 2, and is made of at least one of silicon nitride, magnesium fluoride, silicon oxide, or zinc sulfide.

A front electrode 32 penetrates the front anti-reflection layer 313 to come into electrical contact with the low-absorption coefficient layer 2. A material of the front electrode 32 is selected from at least one of silver, copper, nickel, zinc, or aluminum, to form a single-layer structure or a laminated-layer structure.

A back surface of a solar cell is a conventional Hetero-junction with intrinsic thin-layer (HJT) structure. A back passivation layer 411 is arranged on the back surface of the silicon substrate 1, and is made of intrinsic amorphous silicon. A back transport layer 412 is arranged on a surface of the back passivation layer 411. When the silicon substrate 1 is an n-type or p-type silicon wafer, the back transport layer 412 is a multilayer structure of p-type amorphous silicon or nanocrystalline silicon, and a transparent conductive thin film. A back anti-reflection layer 413 is arranged on a back surface of the back transport layer 412, and is made of silicon nitride; silicon nitride and magnesium fluoride; silicon oxide, silicon nitride, and magnesium fluoride; or the like.

A back electrode 42 penetrates the back anti-reflection layer 413 to come into electrical contact with the back transport layer 412. A material of the back electrode 42 is selected from at least one of silver, copper, nickel, zinc, or aluminum, to form a single-layer structure or a laminated-layer structure.

Embodiment 3

As shown in FIG. 4, a back surface of a solar cell is a dopant-free asymmetric heterocontact (DASH) structure. An n-type silicon wafer is used as a silicon substrate 1. For example, the silicon substrate 1 has a doping concentration ranging from $10^{10}/cm^3$ to $10^{16}/cm^3$, and a thickness ranging from 30 to 150 $\mu$m. For example, the silicon substrate 1 with a low doping concentration of $10^{10}/cm^3$ to $10^{14}/cm^3$ may have a large thickness, which may range from 80 to 150 $\mu$m. The silicon substrate 1 with a high doping concentration of $10^{14}/cm^3$ to $10^{16}/cm^3$ may have a small thickness, which may range from 30 to 80 $\mu$m. A light-receiving surface of the silicon substrate 1 may be a planar structure or a low-roughness light-trapping structure, and a back surface of the silicon substrate 1 has a textured light-trapping structure.

A low-absorption coefficient layer 2 is arranged on the light-receiving surface of the silicon substrate 1. The low-absorption coefficient layer 2 is made of a material including zinc sulfide or zinc selenide, and has a thickness of 15 to 100 nm, for example, 20 to 50 nm. The low-absorption coefficient layer 2 has an n-type conductivity type. Doping may be performed on zinc sulfide or zinc selenide to improve the conductivity or enhance the conductivity type. For example, an element such as aluminum, indium, or gallium may be doped in zinc sulfide or zinc selenide. The low-absorption coefficient layer 2 is prepared by using a process such as chemical vapor deposition, evaporative deposition, or molecular beam epitaxy. Alternatively, the low-absorption coefficient layer 2 may be made of a material including zinc oxide or another foregoing material.

A front passivated contact layer 312 is arranged on the low-absorption coefficient layer 2, and is a transparent conductive thin film, for example, zinc oxide (in which aluminum, indium, or gallium may be doped) or indium tin oxide.

A front anti-reflection layer 313 is arranged on the front passivated contact layer 312, and is made of silicon nitride; silicon nitride and magnesium fluoride; silicon oxide, silicon nitride, and magnesium fluoride; or the like.

A front electrode 32 penetrates the front anti-reflection layer 313 to come into electrical contact with the front passivated contact layer 312, or to come into partial contact with the low-absorption coefficient layer 2. The front electrode 32 is a single-layer or laminated-layer structure formed by at least one of silver, copper, nickel, zinc, or aluminum.

The back surface of the solar cell is the DASH structure. A back passivation layer 411 is arranged on the back surface of the silicon substrate 1, and is made of silicon oxide. A back transport layer 412 is arranged on a surface of the back passivation layer 411, and is made of a laminated material of a wide-band gap transition metal oxide and a transparent conductive thin film. The wide-band gap transition metal oxide has a conductivity type opposite to that of the low-absorption coefficient layer 2. A p-type material can be selected to have a high work function. The p-type material is, for example, molybdenum oxide, tungsten oxide, or vanadium oxide. The p-type material may alternatively be selected as a p-type oxide, for example, nickel oxide. An n-type material may be selected as an n-type oxide, for example, zinc oxide, tin oxide, or titanium oxide. A back anti-reflection layer 413 is arranged on a back surface of the back transport layer 412, and is made of silicon nitride; silicon nitride and magnesium fluoride; silicon oxide, silicon nitride, and magnesium fluoride; or the like.

A back electrode 42 penetrates the back anti-reflection layer 413 to come into electrical contact with the back transport layer 412. A material of the back electrode 42 is selected from at least one of silver, copper, nickel, zinc, or aluminum, to form a single-layer structure or a laminated-layer structure.

It should be noted that, for ease of description, the method embodiments are stated as a combination of a series of actions. However, a person skilled in the art is to know that the embodiments of this application are not limited to the described action sequence, because according to this embodiment of this application, some steps may be performed in another sequence or simultaneously. In addition, a person skilled in the art is also to learn that the embodiments described in this specification are all exemplary embodiments, and the actions involved are not necessarily required by the embodiments of this application.

It should be noted that, the term "include", "comprise", or any other variation thereof in this specification is intended to cover a non-exclusive inclusion, which specifies the presence of stated processes, methods, objects, or apparatuses, but does not preclude the presence or addition of one or more other processes, methods, objects, or apparatuses. Without more limitations, elements defined by the sentence "including one ..." does not exclude that there are still other same elements in the processes, methods, objects, or apparatuses.

The embodiments of this application are described above with reference to the accompanying drawings. However, this application is not limited to the foregoing specific implementations. The foregoing specific implementations are illustrative instead of limitative. Enlightened by this application, a person of ordinary skill in the art can make many forms without departing from the idea of this application and the scope of protection of the claims. All of the forms fall within the protection of this application.

## Claims

1. A solar cell, comprising: a silicon substrate 1, and a low-absorption coefficient layer 2 arranged on a light-receiving surface of the silicon substrate 1, wherein

   the low-absorption coefficient layer 2 and the light-receiving surface of the silicon substrate 1 have a same conductivity type;

in a wavelength band of less than or equal to 400 nm, an absorption coefficient of the low-absorption coefficient layer 2 is less than an absorption coefficient of the silicon substrate 1;

a thickness x of the low-absorption coefficient layer 2 ranges from 15 to 200 nm, and a direction of the thickness is parallel to a direction in which the silicon substrate 1 and the low-absorption coefficient layer 2 are arranged; and

the low-absorption coefficient layer 2 is in direct contact with the silicon substrate 1.

2. The solar cell according to claim 1, wherein a band gap of the low-absorption coefficient layer 2 is greater than or equal to a band gap of the silicon substrate 1.

3. The solar cell according to claim 1, wherein the thickness x of the low-absorption coefficient layer 2 ranges from 20 to 100 nm.

4. The solar cell according to any one of claims 1 to 3, wherein the thickness of the low-absorption coefficient layer 2 is $x = \dfrac{400}{4\pi\kappa_{min}}$, wherein $\kappa_{min}$ is a minimum extinction coefficient of the low-absorption coefficient layer 2 in a wavelength band of 200 to 400 nm.

5. The solar cell according to any one of claims 1 to 3, wherein in a wavelength band of 300 to 400 nm, an extinction coefficient of the low-absorption coefficient layer 2 is greater than or equal to 0.1 and less than or equal to 2.

6. The solar cell according to any one of claims 1 to 3, wherein in a wavelength band of 300 to 400 nm, an integral average extinction coefficient of the low-absorption coefficient layer 2 is greater than or equal to 0.1 and less than or equal to 2.

7. The solar cell according to claim 6, wherein a material of the low-absorption coefficient layer 2 is selected from at least one of boron carbide, zinc oxide, gallium phosphide, indium phosphide, cadmium sulfide, zinc sulfide, arsenic selenide, cadmium selenide, or zinc selenide.

8. The solar cell according to claim 7, wherein the material of the low-absorption coefficient layer 2 is selected from zinc oxide; and the solar cell further comprises: a front anti-reflection layer 313 and a front electrode 32 located on a side of the low-absorption coefficient layer 2 away from the silicon substrate 1, wherein the front electrode 32 penetrates the front anti-reflection layer 313 to come into contact with the low-absorption coefficient layer 2.

9. The solar cell according to any one of claims 1 to 3, wherein the low-absorption coefficient layer 2 has a locally doped region, and the locally doped region is a front selective contact region; or the low-absorption coefficient layer 2 is an entirely doped layer, and the low-absorption coefficient layer 2 is a front selective contact layer; and

the solar cell further comprises: a front electrode 32 located on a side of the low-absorption coefficient layer 2 away from the silicon substrate 1, wherein the front electrode 32 is in contact with the front selective contact region or the front selective contact layer.

10. The solar cell according to any one of claims 1 to 3, further comprising: a buffer layer located between the silicon substrate 1 and the low-absorption coefficient layer 2, wherein a material of the buffer layer is selected from at least one of silicon oxide, zinc sulfide, silicon carbide, aluminum nitride, or silicon nitride.

11. The solar cell according to claim 10, wherein a thickness of the buffer layer is less than or equal to 4 mm, and a direction of the thickness of the buffer layer is parallel to the direction in which the silicon substrate 1 and the low-absorption coefficient layer 2 are arranged.

12. The solar cell according to any one of claims 1 to 3, wherein the light-receiving surface of the silicon substrate 1 has a light-trapping structure.

13. A photovoltaic module, comprising a plurality of solar cells according to any one of claims 1 to 12.

14. A method for preparing the solar cell according to any one of claims 1 to 12, comprising:

arranging a low-absorption coefficient layer 2 on a light-receiving surface of a silicon substrate 1, wherein the low-absorption coefficient layer 2 and the light-receiving surface of the silicon substrate 1 have a same conductivity type; in a wavelength band of less than or equal to 400 nm, an absorption coefficient of the low-absorption coefficient layer 2 is less than an absorption coefficient of the silicon substrate 1; a thickness x of the low-absorption coefficient layer 2 ranges from 15 to 200 nm, and a direction of the thickness is parallel to a direction in which the silicon substrate 1 and the low-absorption coefficient layer 2 are arranged; and the low-absorption coefficient layer 2 is in direct contact with the silicon sub strate 1.

15. The method for preparing the solar cell according to claim 14, wherein the arranging a low-absorption coefficient layer 2 on a light-receiving surface of a silicon substrate 1 comprises:

arranging the low-absorption coefficient layer 2 on the light-receiving surface of the silicon substrate 1 through chemical vapor deposition, evaporation deposition, or molecular beam epitaxy.

FIG. 1

FIG. 2

FIG. 3

FIG. 4

## INTERNATIONAL SEARCH REPORT

| International application No. |
|---|
| **PCT/CN2023/086254** |

**A. CLASSIFICATION OF SUBJECT MATTER**

H01L31/0352(2006.01)i;H01L31/0392(2006.01)i;H01L31/042(2014.01)i;H01L31/18(2006.01)i;H01L31/0216(2014.01)i; H01L31/055(2014.01)i

According to International Patent Classification (IPC) or to both national classification and IPC

**B. FIELDS SEARCHED**

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT: 太阳能, 电池, 光伏, 低, 吸收系数, 硅, 导电类型, 400, 短波, 紫, 响应, 碳化硼, 氧化锌, 磷化镓, 磷化铟, 硫化镉, 硫化锌, 硒化砷, 硒化镉, 硒化锌, solar, cell, battery, low, absorption coefficient, Si, conductive type, shortwave, violet, ZnO, GaP, CdS, CdSe, ZnS, AsSe, ZnSe

**C. DOCUMENTS CONSIDERED TO BE RELEVANT**

| Category* | Citation of document, with indication, where appropriate, of the relevant passages | Relevant to claim No. |
|---|---|---|
| PX | CN 115188844 A (LONGJI LEYE PHOTOVOLTAIC TECH XIXIAN NEW AREA CO., LTD.) 14 October 2022 (2022-10-14) <br> claims 1-15, description, paragraphs [0036]-[0097], and figures 1-4 | 1-15 |
| A | CN 104465814 A (INSTITUTE OF MICROELECTRONICS OF CHINESE ACADEMY OF SCIENCES) 25 March 2015 (2015-03-25) <br> description, paragraphs [0041]-[0061], and figures 1-7 | 1-15 |
| A | CN 103560155 A (NANKAI UNIVERSITY) 05 February 2014 (2014-02-05) <br> entire document | 1-15 |
| A | CN 103367542 A (CHINT SOLAR (ZHEJIANG) CO., LTD.) 23 October 2013 (2013-10-23) <br> entire document | 1-15 |
| A | CN 103258881 A (YANG LIYOU) 21 August 2013 (2013-08-21) <br> entire document | 1-15 |

☐ Further documents are listed in the continuation of Box C. ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **15 May 2023** | **02 June 2023** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/086254**

| Patent document cited in search report | | | Publication date (day/month/year) | Patent family member(s) | | | Publication date (day/month/year) |
|---|---|---|---|---|---|---|---|
| CN | 115188844 | A | 14 October 2022 | None | | | |
| CN | 104465814 | A | 25 March 2015 | None | | | |
| CN | 103560155 | A | 05 February 2014 | WO | 2015066991 | A1 | 14 May 2015 |
| CN | 103367542 | A | 23 October 2013 | None | | | |
| CN | 103258881 | A | 21 August 2013 | TW | 201444104 | A | 16 November 2014 |
| | | | | WO | 2014180281 | A1 | 13 November 2014 |
| | | | | KR | 20170118256 | A | 24 October 2017 |
| | | | | JP | 2016511940 | A | 21 April 2016 |
| | | | | KR | 20160007475 | A | 20 January 2016 |
| | | | | EP | 2996160 | A1 | 16 March 2016 |
| | | | | EP | 2996160 | A4 | 11 January 2017 |
| | | | | US | 2016118519 | A1 | 28 April 2016 |
| | | | | CN | 103258881 | B | 11 November 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210738973X